# EUROPÄISCHE PATENTSCHRIFT

(11) **EP 3 737 999 B1**
(45) Veröffentlichungstag und Bekanntmachung des Hinweises auf die Patenterteilung: **11.03.2026**
(21) Anmeldenummer: 18811203.1
(22) Anmeldetag: 26.11.2018
(51) Int. Cl.: G03F 7/20, G02B 26/08, G02B 5/09

(54) **PUPILLENFACETTENSPIEGEL, BELEUCHTUNGSOPTIK UND OPTISCHES SYSTEM FÜR EINE PROJEKTIONSBELICHTUNGSANLAGE**
PUPIL FACET MIRROR, ILLUMINATION OPTICS AND OPTICAL SYSTEM FOR A PROJECTION LITHOGRAPHY SYSTEM
MIROIR À FACETTES DE PUPILLE, OPTIQUE D'ÉCLAIRAGE ET SYSTÈME OPTIQUE D'UNE INSTALLATION DE LITHOGRAPHIE PAR PROJECTION

(30) Priorität: 08.01.2018 DE 102018200167
(43) Veröffentlichungstag der Anmeldung: 18.11.2020
(73) Patentinhaber: Carl Zeiss SMT GmbH, 73447 Oberkochen (DE)
(72) Erfinder: DEGÜNTHER, Markus, 61197 Florstadt (DE)
(74) Vertreter: Rau, Schneck & Hübner Patentanwälte Rechtsanwälte PartGmbB
(86) Internationale Anmeldenummer: PCT/EP2018/082511
(87) Internationale Veröffentlichungsnummer: WO 2019/134773

(56) Entgegenhaltungen:
- DE-A1- 102014 217 611
- DE-A1- 102014 223 453
- DE-A1- 102015 216 443
- MIGURA SASCHA ET AL: "Anamorphic high-NA EUV lithography optics", VISUAL COMMUNICATIONS AND IMAGE PROCESSING; 20-1-2004 - 20-1-2004; SAN JOSE,, vol. 9661, 4 September 2015 (2015-09-04), pages 96610T - 96610T, XP060057460, ISBN: 978-1-62841-730-2, DOI: 10.1117/12.2196393

## Beschreibung

Die Erfindung betrifft ein optisches System für eine Projektionsbelichtungsanlage, einen Pupillenfacettenspiegel für eine Beleuchtungsoptik und eine Beleuchtungsoptik. Weiter betrifft die Erfindung eine Projektionsbelichtungsanlage für die Mikrolithographie. Schließlich betrifft die Erfindung ein Verfahren zur Belichtung eines Wafers mit Hilfe einer Projektionsbelichtungsanlage.

DE 10 2014 223 453 A1 offenbart eine Beleuchtungsoptik für die Projektionslithografie.

Aus dem Stand der Technik sind Projektionsbelichtungsanlagen mit hohen numerischen Aperturen bekannt. Große Einfallswinkel der Beleuchtungsstrahlung können jedoch zu Abschattungseffekten durch die Maskenstrukturen führen.

Eine Aufgabe der Erfindung besteht darin, ein optisches System für eine Projektionsbelichtungsanlage zu verbessern.

Diese Aufgabe wird gelöst durch ein optisches System nach Anspruch 1.

In einer besonderen Ausführungsform des optischen Systems ist der Winkelraum der Beleuchtungsstrahlung der Projektionsoptik am Retikel in einer ersten Richtung doppelt so groß ist wie der Winkelraum der Beleuchtungsstrahlung der Beleuchtungsoptik. Diese erste Richtung verläuft insbesondere parallel zur Scanrichtung der Projektionsbelichtungsanlage. In der Beleuchtungsoptik kann die Scanrichtung auf Grund der Ausdehnung des ausgeleuchteten Retikels erkannt werden: Das Retikel ist in Scanrichtung deutlich kürzer als in einer hierzu orthogonalen Richtung.

Eine Halbierung des Winkelraums in einer ersten Richtung kann insbesondere dadurch erreicht werden, dass die Öffnung des Strahlenbündels der Beleuchtungsstrahlung im Strahlengang der Projektionsoptik zu einem kreisförmigen Winkelraum auf dem Wafer führt, während die Öffnung des Strahlenbündels der Beleuchtungsstrahlung zur Beleuchtung des Retikels in der ersten Richtung im Vergleich dazu auf die Hälfte reduziert ist. Bei einer astigmatischen Abbildung durch die Projektionsoptik kann der Winkelraum der Beleuchtungsstrahlung im Strahlengang der Projektionsoptik insbesondere elliptisch sein.

Wenn von Öffnung bzw. Winkelraum der Strahlenbündels der Beleuchtungsstrahlung im Strahlengang der Projektionsoptik gesprochen wird, so sind hierunter nur diejenigen Strahlen verstanden, die innerhalb der von der Projektionsoptik aufgenommenen Apertur liegen, also den Wafer auch erreichen können.

In der ersten Richtung ist die numerische Apertur der Beleuchtungsoptik insbesondere gerade halb so groß wie die numerische Apertur der Projektionsoptik.

Erfindungsgemäß wurde erkannt, dass sich hierdurch der maximale Einfallswinkel der Beleuchtungsstrahlung am Retikel reduzieren lässt. Die Konsequenz der Halbierung der Beleuchtungspupille auf die Abbildung des Retikels lässt sich durch eine nachfolgende zweite Belichtung mit der anderen Hälfte der Beleuchtungspupille kompensieren. Dies wird nachfolgend noch näher beschrieben.

Gemäß einem weiteren Aspekt der Erfindung ist das Retikel relativ zum Strahlengang der Beleuchtungsstrahlung derart verkippt, dass seine Flächennormale vollständig im Strahlenbündel der Beleuchtungsstrahlung der Projektionsoptik liegt. Wegen der unterschiedlichen Öffnungswinkel der auf das Retikel auftreffenden und der vom Retikel reflektierten Beleuchtungsstrahlung liegt die Flächennormale des Retikels insbesondere nicht mehr symmetrisch zwischen dem Strahlenbündel der Beleuchtungsoptik und dem der Projektionsoptik, sondern vollständig innerhalb des Strahlenbündels der Projektionsoptik.

Gemäß einem weiteren Aspekt der Erfindung umfasst das optische System einen halbkreisförmigen Pupillenfacettenspiegel. Der Pupillenfacettenspiegel wird nachfolgend noch näher beschrieben.

Gemäß einem weiteren Aspekt der Erfindung umfasst das optische System eine Projektionsoptik mit einer objektseitigen numerischen Apertur von mindestens 0,55, insbesondere mindestens 0,7.

Gemäß einem weiteren Aspekt der Erfindung ist der Winkelraum der Beleuchtungsstrahlung der Projektionsoptik am Retikel in einer zweiten Richtung gleich groß wie der Winkelraum der Beleuchtungsstrahlung der Beleuchtungsoptik. Die zweite Richtung ist hierbei insbesondere senkrecht zur ersten Richtung orientiert.

Zur Auflösung von Strukturen des Retikels an der Auflösungsgrenze wird von den beiden ersten Beugungsordnungen der am Retikel reflektierten Beleuchtungsstrahlung nur ein Teil der einen zur Projektion des Retikels auf den Wafer verwendet.

Im Strahlenbündel der Projektionsoptik ist insbesondere neben der am Retikel spekular reflektierten Beleuchtungsstrahlung, das heißt der nullten Beugungsordnung, lediglich ein Teil entweder der +1. oder der -1. Beugungsordnung enthalten. Hierbei kann die +1./-1. Beugungsordnung insbesondere beschnitten, das heißt nur teilweise, insbesondere nicht vollständig, im Strahlenbündel der Projektionsoptik enthalten sein. Dies gilt entsprechend für höhere Beugungsordnungen.

Gemäß einem weiteren Aspekt der Erfindung sind sowohl das Retikel als auch der Wafer um jeweils 180° rotierbar. Sie sind insbesondere entsprechend rotierbar auf einem Retikel- bzw. Waferhalter gelagert.

Dies ermöglicht es, das Retikel mit der anderen Hälfte der Beleuchtungspupille zu beleuchten. Hierbei werden dieselben Maskenstrukturen, d.h., dieselbe im Retikel eingelegte Maske, auf dieselben Bereiche des Wafers abgebildet. Dies ist zu unterscheiden sowohl von Double Exposure, bei dem nacheinander unterschiedliche Masken mittels unterschiedlicher Beleuchtungspupillen auf denselben Bereich des Wafers abgebildet werden, als auch von Double Patterning, bei dem zwischen zwei Belichtungen desselben Bereichs auf dem Wafer eine Entwicklung des auf dem Wafer aufgetragenen Photoresists stattfindet.

Gemäß einem weiteren Aspekt der Erfindung weist die Projektionsoptik eine Mehrzahl von Spiegeln auf, wobei die ersten beiden Spiegel, insbesondere die ersten drei Spiegel, insbesondere die ersten vier Spiegel im Strahlengang der Projektionsoptik, eine einfach zusammenhängende Reflexionsfläche aufweisen.

Hierdurch kann die Notwendigkeit einer fraktionierten Reflexionsfläche dieser Spiegel der Projektionsoptik vermieden werden.

Das Vermeiden einer fraktionierten Reflexionsfläche erlaubt es insbesondere, die Strahlengänge zwischen Retikel und Beleuchtungsoptik von denen zwischen Retikel und Projektionsoptik zu trennen.

Es sind weitere Aufgaben der Erfindung, eine Beleuchtungsoptik für eine Projektionsbelichtungsanlage und einen Pupillenfacettenspiegel für eine Beleuchtungsoptik einer Projektionsbelichtungsanlage zu verbessern.

Diese Aufgaben werden durch eine Beleuchtungsoptik, welche derart ausgebildet ist, dass lediglich eine halbe Beleuchtungspupille zur Beleuchtung des Retikels zur Verfügung steht, und einen Pupillenfacettenspiegel mit einer halbkreisförmigen Ausbildung gelöst.

Die Beleuchtungsoptik weist eine ausgangsseitige Apertur auf, welche in einer ersten Richtung kleiner ist als in einer hierzu senkrechten zweiten Richtung. Das Verhältnis der Durchmesser der ausgangsseitigen Apertur der Beleuchtungsoptik in der ersten und zweiten Richtung beträgt höchstens 0,7, insbesondere höchstens 0,6. Es kann insbesondere 0,5 betragen.

Dies kann insbesondere dadurch erreicht werden, dass relativ zu einer kreisförmigen ausgangsseitigen Apertur die Hälfte derselben abgeschnitten wird. Dies ist insbesondere durch eine geeignete Ausbildung des Pupillenfacettenspiegels möglich. Die Beleuchtungsoptik weist insbesondere eine halbkreisförmige Apertur auf.

Der Pupillenfacettenspiegel kann auch halbelliptisch ausgebildet sein. Hierunter sei verstanden, dass er die Form der Hälfte einer symmetrisch geteilten Ellipse aufweist.

Unter der Form des Pupillenfacettenspiegels sei insbesondere dessen Envelope, das heißt die Form seiner kleinsten konvexen Einhüllenden, verstanden. Die Form gibt insbesondere den Bereich vor, in welchem die Pupillenfacetten angeordnet sein können.

Gemäß einem weiteren Aspekt der Erfindung wird eine Beleuchtungsoptik, welche lediglich eine halbe Beleuchtungspupille zur Beleuchtung des Retikels zur Verfügung stellt, durch eine Blende zur Ausblendung einer Hälfte der Beleuchtungspupille gebildet.

Erfindungsgemäß wurde erkannt, dass sich durch Zurverfügungstellung nur einer Hälfte der Beleuchtungspupille die Öffnung des Strahlenbündels der Beleuchtungsstrahlung zur Beleuchtung des Retikels in einer Richtung auf die Hälfte reduzieren lässt. Hierdurch kann der maximale Einfallswinkel der Beleuchtungsstrahlung auf die Maske reduziert werden. Insbesondere können hierdurch Abschattungseffekte reduziert werden.

Eine weitere Aufgabe der Erfindung besteht darin, eine Projektionsbelichtungsanlage für die Mikrolithographie zu verbessern.

Diese Aufgabe wird durch eine Projektionsbelichtungsanlage mit einem optischen System gemäß der vorhergehenden Beschreibung gelöst.

Die Vorteile ergeben sich aus den bereits beschriebenen.

Bei der Projektionsbelichtungsanlage handelt es sich insbesondere um eine EUV-Projektionsbelichtungsanlage. Sie umfasst insbesondere eine Strahlungsquelle zur Erzeugung von Beleuchtungsstrahlung im EUV-Bereich, insbesondere im Wellenlängenbereich von weniger als 30 nm, insbesondere zur Beleuchtung von Beleuchtungsstrahlung mit einer Wellenlänge von 13,5 nm oder 7 nm.

Eine weitere Aufgabe der Erfindung besteht darin, ein Verfahren zur Belichtung eines Wafers mit Hilfe einer Projektionsbelichtungsanlage zu verbessern.

Diese Aufgabe wird durch ein Verfahren gelöst, bei welchem ein Retikel nacheinander zweimal auf den Wafer projiziert wird, wobei das Retikel und der Wafer zwischen den beiden Belichtungsschritten um jeweils 180° um die optische Achse rotiert werden.

Auf diese Weise ist es möglich, die beiden Hälften einer Beleuchtungspupille sequenziell zur Beleuchtung des Retikels und Abbildung der Strukturen desselben auf den Wafer zu verwenden. Auf diese Weise lässt sich der Effekt der vorhergehend beschriebenen Pupillenhalbierung kompensieren, insbesondere im Wesentlichen vollständig kompensieren.

Bei dem Verfahren handelt es sich um ein Zweifachbelichtungsverfahren.

Aufgrund der reduzierten Abschattungseffekte bei gleichzeitig hoher numerischer Apertur, insbesondere der Projektionsoptik, lässt sich insbesondere die Präzision der Strukturen auf dem Wafer weiter verbessern.

Weitere Details und Vorteile der Erfindung ergeben sich aus der Beschreibung von Ausführungsbeispielen anhand der Figuren. Es zeigen:
- Fig. 1: schematisch einen Meridionalschnitt durch eine Projektionsbelichtungsanlage für die Mikrolithographie,
- Fig. 2: schematisch eine Aufsicht auf den Pupillenfacettenspiegel der Beleuchtungsoptik der Projektionsbelichtungsanlage gemäß Fig. 1,
- Fig. 3: eine Ausschnittsvergrößerung des Bereichs III im Strahlengang der Projektionsbelichtungsanlage gemäß Fig. 1,
- Fig. 4: schematisch einen Schnitt entlang der Linie IV-IV gemäß Fig. 3 durch die Strahlenbündel der Beleuchtungsstrahlung der Beleuchtungsoptik und der Projektionsoptik im Bereich des Retikels,
- Fig. 5: schematisch die Anordnung von Retikel und Wafer bei einem ersten Belichtungsschritt und
- Fig. 6: schematisch die Anordnung von Retikel und Wafer bei einem nachfolgenden zweiten Belichtungsschritt.

Im Folgenden werden zunächst exemplarisch die allgemeinen Details einer an sich bekannten Projektionsbelichtungsanlage 1 für die Mikrolithographie beschrieben. Stellvertretend sei hierfür auf die DE 10 2012 220 597 A1 verwiesen, die hiermit vollständig als Bestandteil der vorliegenden Anmeldung in diese integriert ist. Dieser Verweis ist nicht einschränkend zu verstehen. Abweichungen in unterschiedlichen Details der Projektionsbelichtungsanlage 1 sind möglich.

Eine Projektionsbelichtungsanlage 1 für die Mikrolithografie dient zur Herstellung eines mikro-beziehungsweise nanostrukturierten elektronischen Halbleiter-Bauelements. Eine Strahlungsquelle 2 emittiert zur Beleuchtung genutzte EUV-Strahlung im Wellenlängenbereich beispielsweise zwischen 5 nm und 30 nm. Bei der Strahlungsquelle 2 kann es sich um eine GDPP-Quelle (Plasmaerzeugung durch Gasentladung, gas discharge produced plasma) oder um eine LPP-Quelle (Plasmaerzeugung durch Laser, laser produced plasma) handeln. Auch eine Strahlungsquelle, die auf einem Synchrotron oder einem Freie Elektronen Laser (FEL) basiert, ist für die Strahlungsquelle 2 einsetzbar. Informationen zu einer derartigen Strahlungsquelle findet der Fachmann beispielsweise in der US 6 859 515 B2. Zur Beleuchtung und Abbildung innerhalb der Projektionsbelichtungsanlage 1 wird EUV-Beleuchtungslicht beziehungsweise Beleuchtungsstrahlung in Form eines Abbildungslicht-Bündels 3 genutzt. Das Abbildungslicht-Bündel 3 durchläuft nach der Strahlungsquelle 2 zunächst einen Kollektor 4, bei dem es sich beispielsweise um einen genesteten Kollektor mit einem aus dem Stand der Technik bekannten Mehrschalen-Aufbau oder alternativ um einen, dann hinter der Strahlungsquelle 2 angeordneten ellipsoidal geformten Kollektor handeln kann. Ein entsprechender Kollektor ist aus der EP 1 225 481 A bekannt. Die Strahlungsquelle 2 und der Kollektor 4 können Bestandteile eines Strahlungsquellenmoduls 8 sein.

Nach dem Kollektor 4 durchtritt das EUV-Beleuchtungslicht 3 zunächst eine Zwischenfokusebene 5, was zur Trennung des Abbildungslicht-Bündels 3 von unerwünschten Strahlungs- oder Partikelanteilen genutzt werden kann. Nach Durchlaufen der Zwischenfokusebene 5 trifft das Abbildungslicht-Bündel 3 zunächst auf einen Feldfacettenspiegel 6 mit Feldfacetten 7. Der Feldfacettenspiegel 6 stellt einen ersten Facettenspiegel der Projektionsbelichtungsanlage 1 dar.

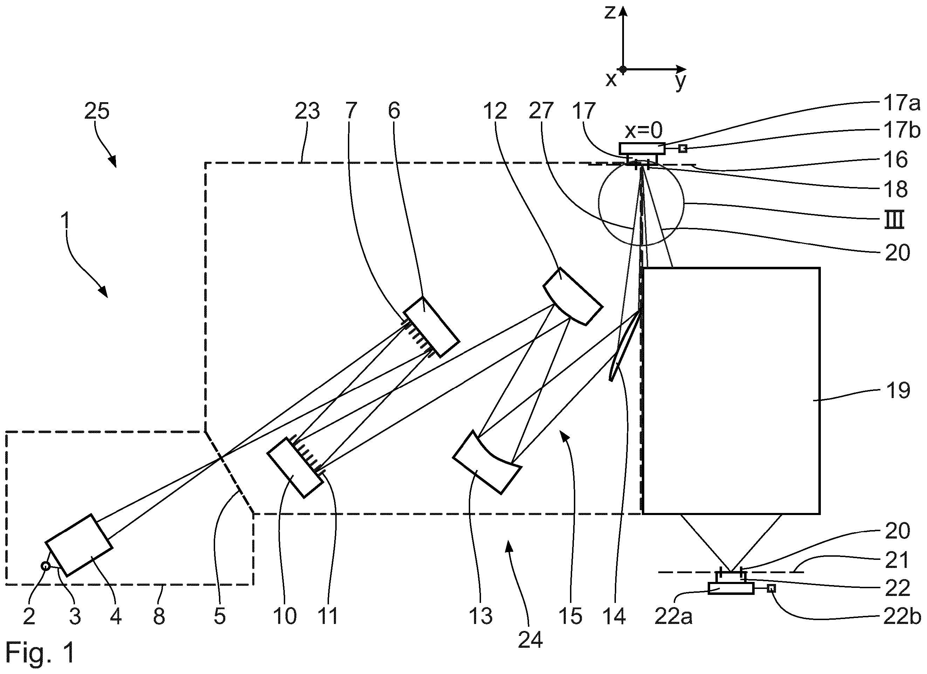

Zur Erleichterung der Beschreibung von Lagebeziehungen ist in der Zeichnung jeweils ein kartesisches globales xyz-Koordinatensystem eingezeichnet. Die x-Achse verläuft in der Fig. 1 senkrecht zur Zeichenebene und aus dieser heraus. Die y-Achse verläuft in der Fig. 1 nach rechts. Die z-Achse verläuft in der Fig. 1 nach oben.

Die Feldfacetten 7 sind umstellbar zwischen jeweils drei verschiedenen Kippstellungen. Je nach Ausführung des Feldfacettenspiegels 6 können alle oder auch einige der Feldfacetten 7 auch zwischen mehr als drei verschiedenen Kippstellungen umstellbar sein. Hierzu ist jede der Feldfacetten jeweils mit einem Aktor verbunden. Die Aktoren aller verkippbaren Feldfacetten 7 können über eine zentrale Steuereinrichtung angesteuert werden.

Nach Reflexion am Feldfacettenspiegel 6 trifft das in Abbildungslicht-Teilbündel, die den einzelnen Feldfacetten 7 zugeordnet sind, aufgeteilte Abbildungslicht-Bündel 3 auf einen nachfolgend noch näher beschriebenen Pupillenfacettenspiegel 10. Das jeweilige Abbildungslicht-Teilbündel des gesamten Abbildungslicht-Bündels 3 ist längs jeweils eines Abbildungslichtkanals geführt.

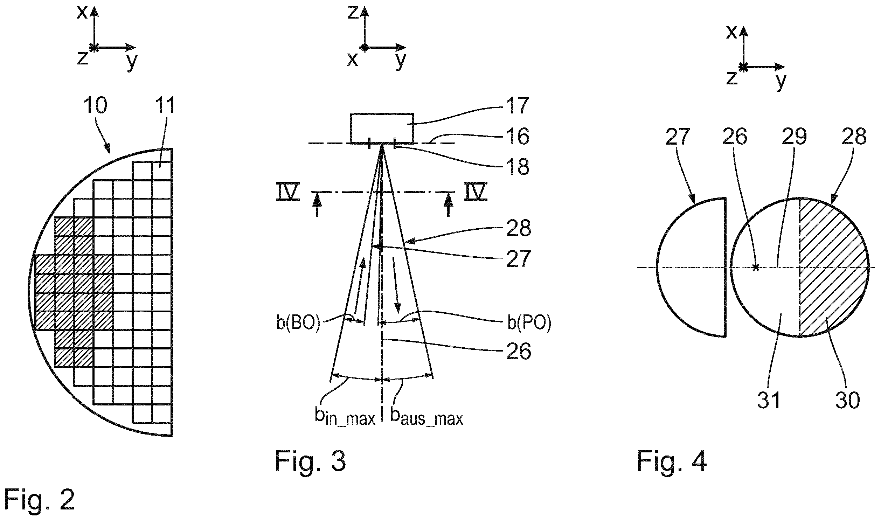

Fig. 2 zeigt stark schematisch eine beispielhafte Facettenanordnung von Pupillenfacetten 11 des Pupillenfacettenspiegels 10. Der Pupillenfacettenspiegel 10 stellt einen zweiten Facettenspiegel der Projektionsbelichtungsanlage 1 dar. Die Pupillenfacetten 11 sind auf einer Trägerplatte des Pupillenfacettenspiegels 10 angeordnet. Die Pupillenfacetten 11 sind zeilen- und spaltenweise in einem x/y-Raster angeordnet. Alternativ sind die Pupillenfacetten 11 auf einem hexagonalen Raster angeordnet. Die Pupillenfacetten 11 haben quadratische Reflexionsflächen. Auch andere Formen von Reflexionsflächen sind möglich, zum Beispiel rechteckig, rund oder mehreckig, zum Beispiel sechseckig oder achteckig. Auch rautenförmig angeordnete Pupillenfacetten 11 sind möglich.

Jedem von einer der Feldfacetten 7 in einer der drei Kippstellungen reflektierten Abbildungslicht-Teilbündel des EUV-Beleuchtungslichts 3 ist genau eine Pupillenfacette 11 zugeordnet, so dass jeweils ein beaufschlagtes Facettenpaar mit genau einer der Feldfacetten 7 und genau einer der Pupillenfacetten 11 den Abbildungslichtkanal für das zugehörige Abbildungslicht-Teilbündel des EUV-Beleuchtungslichts 3 vorgibt. In jeder Kippstellung der jeweiligen Feldfacette 7 ist dieser Feldfacette 7 also genau eine Pupillenfacette 11 zum Ablenken des EUV-Beleuchtungslichts 3 in Richtung dieser Pupillenfacette 11 zugeordnet.

Die kanalweise Zuordnung der Pupillenfacetten 11 zu den Feldfacetten 7 erfolgt abhängig von einer gewünschten Beleuchtung durch die Projektionsbelichtungsanlage 1. Aufgrund der verschiedenen Feldfacetten-Kippstellungen kann jede der Feldfacetten 7 also verschiedene Abbildungslichtkanäle vorgeben. Jeder der Feldfacetten 7 ist über alle ihre Kippstellungen eine Menge von der Anzahl der Kippstellungen entsprechenden Pupillenfacetten 11 zugeordnet.

Bei einer alternativen Ausgestaltung können die Feldfacetten 7 auch zwischen zwei Kippstellungen, zwischen vier Kippstellungen oder zwischen noch mehr Kippstellungen umstellbar sein und hierdurch jeweils einen Abbildungslichtkanal vorgeben. Entsprechend größer ist dann die Anzahl der Pupillenfacetten 11 in der jeweiligen Pupillenfacetten-Menge.

Der Feldfacettenspiegel 6 kann neben Feldfacetten 7, die zwischen mehreren Kippstellungen umstellbar sind, auch Feldfacetten 7 aufweisen, die nicht umstellbar sind, sondern fest jeweils einer Pupillenfacette zugeordnet sind. Eine derartige Variante mit nicht umstellbaren Feldfacetten 7 kommt insbesondere dann zum Einsatz, wenn sich die verschiedenen vorzugebenden Beleuchtungssettings so überschneiden, dass bei allen vorzugebenden Beleuchtungssettings Licht aus bestimmten gleichen Richtungen benötigt wird, sodass bestimmte Pupillenfacetten unabhängig vom vorzugebenden Beleuchtungssetting immer mit dem EUV-Beleuchtungslicht beaufschlagt sind.

In der Fig. 2 sind exemplarisch diejenigen Pupillenfacetten 11 des Pupillenfacettenspiegels 10 hervorgehoben, die aufgrund einer momentanen Kippstellung der Feldfacetten 7 mit dem Beleuchtungslicht 3 beaufschlagt sind. Exemplarisch dargestellt ist in der Fig. 2 ein Beleuchtungssetting, welches einem halben x-Dipolsetting, insbesondere gerade einem der Pole eines derartigen x-Dipolsettings, entspricht. Dieses Beleuchtungssetting entspricht einer Beleuchtungswinkelverteilung, die über die Projektionsbelichtungsanlage 1 vorgegeben werden kann. Die mit dem Beleuchtungslicht 3 beaufschlagten Pupillenfacetten 11 bilden bei jedem Beleuchtungssetting mindestens eine zusammenhängende Pupillenfacetten-Gruppe. Grundsätzlich können, je nach den momentanen Kippstellungen der Feldfacetten 7, auch Beleuchtungssettings mit nicht zusammenhängenden Verteilungen von mit dem Beleuchtungslicht 3 beaufschlagten Pupillenfacetten 11 realisiert werden. Auch Mischformen von Beleuchtungssettings mit mindestens einer zusammenhängenden Pupillenfacetten-Gruppe und mit mindestens einer isoliert beaufschlagten Pupillenfacette 11 sind möglich. Ein derartiges, isoliert beaufschlagte Pupillenfacetten 11 aufweisendes Beleuchtungssetting kann in Fällen realisiert werden, in denen eine deutlich größere Anzahl von Pupillenfacetten im Vergleich zur Anzahl der Feldfacetten vorliegt, wobei mit der geringeren Anzahl der Feldfacetten die Pupillenfacetten auf dem Pupillenfacettenspiegel 10 zum Beispiel möglichst gleichverteilt beaufschlagt werden sollen. Sofern das Beleuchtungssetting mindestens eine zusammenhängende Pupillenfacetten-Gruppe aufweist, beinhaltet diese Pupillenfacetten-Gruppe mindestens zwei Pupillenfacetten 11.

Über den Pupillenfacettenspiegel 10 (Fig. 1) und eine nachfolgende, aus drei EUV-Spiegeln 12, 13, 14 bestehenden Übertragungsoptik 15 werden die Feldfacetten 7 in eine Objektebene 16 der Projektionsbelichtungsanlage 1 abgebildet. Der EUV-Spiegel 14 ist als Spiegel für streifenden Einfall (Grazing-Incidence-Spiegel) ausgeführt. In der Objektebene 16 ist ein Retikel 17 angeordnet, von dem mit dem EUV-Beleuchtungslicht 3 ein Ausleuchtungsbereich ausgeleuchtet wird, der mit einem Objektfeld 18 einer nachgelagerten Projektionsoptik 19 der Projektionsbelichtungsanlage 1 zusammenfällt. Der Ausleuchtungsbereich wird auch als Beleuchtungsfeld bezeichnet. Das Objektfeld 18 ist je nach der konkreten Ausführung einer Beleuchtungsoptik der Projektionsbelichtungsanlage 1 rechteckig oder bogenförmig. Die Abbildungslichtkanäle werden im Objektfeld 18 überlagert. Das EUV-Beleuchtungslicht 3 wird vom Retikel 17 reflektiert. Das Retikel 17 wird von einem Retikelhalter 17a gehaltert, der längs der Verlagerungsrichtung y mit Hilfe eines schematisch angedeuteten Objektverlagerungsantriebs 17b angetrieben verlagerbar ist.

Auf die Übertragungsoptik 15 kann verzichtet werden, sofern der Pupillenfacettenspiegel 10 direkt in einer Eintrittspupille der Projektionsoptik 19 angeordnet ist.

Die Projektionsoptik 19 bildet das Objektfeld 18 in der Objektebene 16 in ein Bildfeld 20 in einer Bildebene 21 ab. In dieser Bildebene 21 ist ein Wafer 22 angeordnet, der eine lichtempfindliche Schicht trägt, die während der Projektionsbelichtung mit der Projektionsbelichtungsanlage 1 belichtet wird. Der Wafer 22, also das Substrat, auf welches abgebildet wird, wird von einem Wafer- beziehungsweise Waferhalter 22a gehaltert, der längs der Verlagerungsrichtung y mit Hilfe eines ebenfalls schematisch angedeuteten Waferverlagerungsantriebs 22b synchron zur Verlagerung des Retikelhalters 17a verlagerbar ist. Bei der Projektionsbelichtung werden sowohl das Retikel 17 als auch der Wafer 22 in der y-Richtung synchronisiert gescannt. Die Projektionsbelichtungsanlage 1 ist als Scanner ausgeführt. Die Scanrichtung y ist die Objektverlagerungsrichtung.

Der Feldfacettenspiegel 6, der Pupillenfacettenspiegel 10 und die Spiegel 12 bis 14 der Übertragungsoptik 15 sind Bestandteile einer Beleuchtungsoptik 23 der Projektionsbelichtungsanlage 1.

Gemeinsam mit der Projektionsoptik 19 bildet die Beleuchtungsoptik 23 ein optisches System 24 der Projektionsbelichtungsanlage 1.

Gemeinsam mit dem Strahlungsquellenmodul 8 bildet die Beleuchtungsoptik 23 ein Beleuchtungssystem 25 der Projektionsbelichtungsanlage 1.

Im Folgenden werden weitere Details der Projektionsbelichtungsanlage 1, insbesondere der Beleuchtungsoptik 23, insbesondere des Pupillenfacettenspiegels 10, beschrieben.

Die Beleuchtungsoptik 23 kann vorzugsweise eine hohe numerische Apertur, insbesondere eine numerische Apertur von mindestens 0,55, insbesondere mindestens 0,65, insbesondere mindestens 0,7 aufweisen. Erfindungsgemäß wurde jedoch erkannt, dass große Einfallswinkel der Beleuchtungsstrahlung im Bereich des Retikels 17 zu unerwünschten Abschattungseffekten führen können.

Aus Gründen der Strahlungsführung der Beleuchtungsstrahlung ist der Strahlengang der Beleuchtungsstrahlung der Beleuchtungsoptik 23 üblicherweise derart zu einer Normalen 26 des Retikels 17 verkippt, dass der Strahlengang der Beleuchtungsoptik 23 überlappungsfrei zum Strahlengang der Projektionsoptik 19 ist. Der Strahlengang der Beleuchtungsoptik 23 ist insbesondere derart verkippt, dass er nicht mit dem vom Retikel 17 spekular reflektierten Strahlenbündel, das heißt der in die nullte Ordnung gebeugten Beleuchtungsstrahlung, im Strahlengang der Projektionsoptik 19 überlappt.

Abschattungseffekte können zumindest teilweise durch eine anamorphotische Ausbildung der Projektionsoptik 19 kompensiert werden. Dies führt jedoch zu einer Reduzierung der transportierten Informationen und damit zu einer Reduzierung des Durchsatzes der Projektionsbelichtungsanlage 1. Die hier beschriebene Erfindung kann mit einer anamorphotische Ausbildung der Projektionsoptik 19 kombiniert werden. Auf eine vorteilhafte Gestaltung wird später noch eingegangen.

Erfindungsgemäß ist vorgesehen, den maximalen Einfallswinkel der Beleuchtungsstrahlung am Retikel 17 durch eine Reduzierung der Öffnung des Strahlenbündels 3 der Beleuchtungsstrahlung im Strahlengang der Beleuchtungsoptik 23 am Retikel 17 zu reduzieren.

Dies kann beispielsweise dadurch erreicht werden, dass anstelle eines kreisförmigen Pupillenfacettenspiegels 10 lediglich ein halbkreisförmiger Pupillenfacettenspiegel 10 (siehe Fig. 2) verwendet wird.

In den Fig. 3 und 4 sind schematisch und exemplarisch das Strahlenbündel 27 der Beleuchtungsoptik 23 im Bereich des Retikels 17 und das Strahlenbündel 28 der Projektionsoptik 19 im Bereich des Retikels 17 dargestellt. Eine gestrichelte Linie 29 verdeutlicht in der Fig. 4 die Zeichenebene der Fig. 3.

Dargestellt ist insbesondere die maximale Ausdehnung des Strahlenbündels 27 der Beleuchtungsoptik 23, das heißt die objektseitige Apertur der Beleuchtungsoptik 23, sowie die der Projektionsoptik 19. Der entsprechende Bereich ist nicht notwendigerweise vollständig mit Beleuchtungsstrahlung gefüllt (siehe beispielsweise die exemplarische Darstellung in Fig. 2).

Wie in den Fig. 3 und 4 exemplarisch dargestellt ist, kann der Öffnungswinkel b(BO) des Strahlenbündels 27 der Beleuchtungsoptik 23 gerade halb so groß sein wie der Öffnungswinkel b(PO) des Strahlenbündels 28 der Projektionsoptik 19 in einer ersten Richtung.

Bei der ersten Richtung kann es sich insbesondere um die y-Richtung, das heißt die Scanrichtung, handeln.

In einer hierzu senkrechten, zweiten Richtung können die Strahlungsbündel 27, 28 der Beleuchtungsstrahlung im Strahlengang der Beleuchtungsoptik 23 und im Strahlengang der Projektionsoptik 19 identische Öffnungswinkel aufweisen (siehe Fig. 4).

Weiter ist vorgesehen, das Strahlenbündel 27 der Beleuchtungsstrahlung in der Beleuchtungsoptik 23 derart relativ zum Retikel 17 zu verkippen, dass der maximale Einfallswinkel b_{in_max} der Beleuchtungsstrahlung am Retikel 17 gerade so groß ist wie der maximale Ausfallwsinkel b_{aus_max} der spekular am Retikel 17 reflektierten Beleuchtungsstrahlung.

Wegen der unterschiedlichen Öffnungen der Strahlenbündel 27, 28 im Strahlengang der Beleuchtungsoptik 23 und im Strahlengang der Projektionsoptik 19 führt dies dazu, dass die Flächennormale 26 am Retikel 17 vollständig im Bereich des Strahlenbündels 28 der Projektionsoptik 19 liegt.

Bei Verwendung einer anamorphotischen Projektionsoptik 19 besteht eine besonders vorteilhafte Ausgestaltung darin, die Vergrößerungsmaßstäbe derart zu wählen, dass die Gesamtwinkelausdehnung in x- und y-Richtung identisch ist. Die Ausdehnung des Strahlungsbündels 28 der Beleuchtungsstrahlung im Strahlengang der Projektionsoptik 19 im Winkelraum kann in x-Richtung 50% größer als in y-Richtung sein. Dies führt dazu, dass der maximale Winkel eines Strahls gegenüber der Normalen des Retikels unabhängig von der Richtung ist.

Obwohl die Flächennormale 26 des Retikels 17 vollständig im Strahlengang der Projektionsoptik 19 liegt, können die ersten beiden Spiegel, insbesondere die ersten drei Spiegel, insbesondere die ersten vier Spiegel im Strahlengang der Projektionsoptik 19 eine einfach zusammenhängende Reflexionsfläche aufweisen. Sie weisen insbesondere eine Reflexionsfläche auf, welche nicht fraktioniert ist.

In der Fig. 4 ist exemplarisch dargestellt, dass die spekular reflektierte nullte Ordnung der Beleuchtungsstrahlung vollständig (schraffierter Bereich 30) im Strahlenbündel 28 der Projektionsoptik 19 enthalten ist. Das Strahlenbündel 28 der Projektionsoptik 19 enthält darüber hinaus Anteile höherer Ordnungen (unschraffierter Bereich 31). Das Strahlenbündel 28 der Projektionsoptik 19 enthält jedoch lediglich Anteile höherer Ordnungen, welche auf einer Seite des Bereichs 30 der nullten Ordnung liegen, insbesondere in y-Richtung. Die Anteile höherer Ordnungen liegen insbesondere in einem Bereich zwischen dem Strahlenbündel 27 der Beleuchtungsoptik 23 und dem spekularen Reflex desselben.

Wie der Fig. 4 weiter entnehmbar ist, findet die Reduktion der Öffnung des Strahlenbündels 27 der Beleuchtungsoptik 23 nur in der ersten Richtung, insbesondere der y-Richtung, statt. In einer zweiten, hierzu senkrechten Richtung, insbesondere der x-Richtung, findet keine Reduzierung der Öffnung des Strahlenbündels 27 statt.

Das Strahlenbündel 27 der Beleuchtungsoptik 23 hat somit unterschiedliche Maximalausdehnungen. In einem anamorphotischen System sind die Maximalausdehnungen jeweils relativ zur numerischen Apertur der Projektionsoptik in der entsprechenden Richtung zu nehmen.

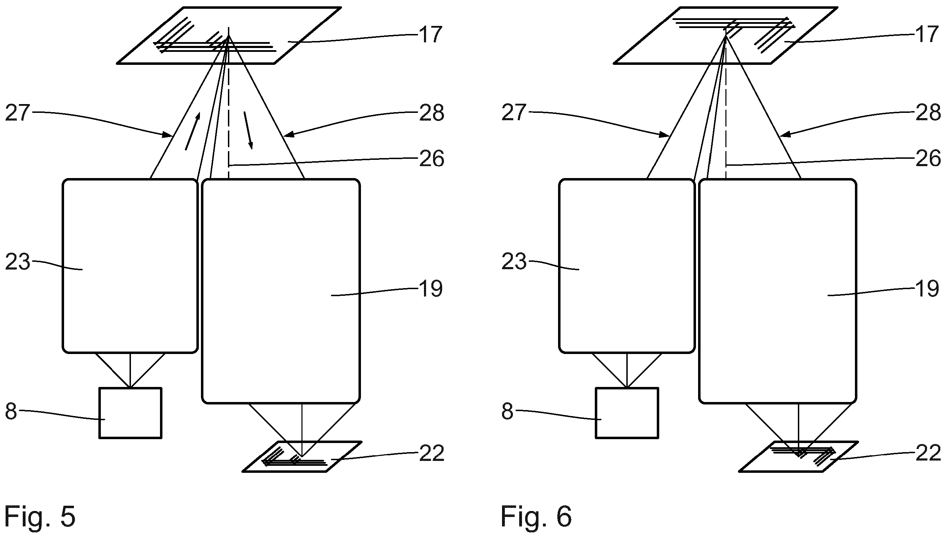

Erfindungsgemäß wurde erkannt, dass die Konsequenz der vorhergehend beschriebenen Halbierung der Beleuchtungspupille auf die Abbildung des Retikels 17 auf den Wafer 22 durch eine Zweifachbelichtung kompensiert werden kann. Bei dieser Zweifachbelichtung werden die beiden komplementären Hälften der Beleuchtungspupille sequenziell zur Abbildung des Retikels 17 auf den Wafer 22 genutzt. Hierbei bleibt das optische System 24 der Projektionsbelichtungsanlage 1 unverändert, während das Retikel 17 und der Wafer 22 um die optische Achse herum gedreht werden. Das Retikel 17 und der Wafer 22 werden insbesondere um 180° um die optische Achse herum gedreht. Die Anordnungen des Retikels 17 und des Wafers 22 in den beiden Belichtungsschritten sind exemplarisch in den Fig. 5 und 6 dargestellt.

Es sei darauf hingewiesen, dass die eben beschriebene doppelte Belichtung vorteilhaft sein kann, nicht aber notwendig ist. Ohne diese doppelte Belichtung führt ein Fokusfehler bzw. ein z-Lagenfehler von Retikel und/oder Wafer zu einer Verschiebung sowie zu einer Auswaschung der auf dem Wafer erzeugten Strukturen. Mit der beschriebenen Doppelbelichtung kann die Verschiebung deutlich verringert werden, allerdings kann dieses mit einer Vergrößerung der Auswaschung der Strukturen einhergehen. Je nach gewünschter Anwendung der Projektionsbelichtungsanlage kann die beschriebene doppelte Belichtung also notwendig, vorteilhaft aber nicht notwendig, oder aber unvorteilhaft sein.

Zur Rotation des Retikels 17 dient der Retikelhalter 17a.

Zur Rotation des Wafers 22 dient der Waferhalter 22a.

Aus der Perspektive des Retikels 17 werden die Strukturen desselben bei den beiden Belichtungsschritten jeweils mit komplementären Hälften der Beleuchtungspupille beleuchtet.

Mit Hilfe der vorhergehend beschriebenen Lösung kann der maximale Einfalls-/Ausfallswinkel der Beleuchtungsstrahlung am Retikel um 25% reduziert werden.

## Patentansprüche

1. Optisches System (24) für eine Projektionsbelichtungsanlage (1) umfassend
1.1. eine Beleuchtungsoptik (23) zur Überführung von Beleuchtungsstrahlung zu einem Retikel (17) und
1.2. eine Projektionsoptik (19) zur Projektion des Retikels (17) auf einen Wafer (22), **gekennzeichnet dadurch, dass**
1.3. der Winkelraum der Beleuchtungsstrahlung der Beleuchtungsoptik (23) und der Projektionsoptik (19) am Retikel (17) derart ausgebildet sind, dass von den beiden ersten Beugungsordnungen der am Retikel (17) reflektierten Beleuchtungsstrahlung lediglich eine im Strahlenbündel der Projektionsoptik (19) enthalten ist.

2. Optisches System (24) gemäß Anspruch 1, **dadurch gekennzeichnet, dass** der Winkelraum der Beleuchtungsstrahlung der Projektionsoptik (19) am Retikel (17) in einer ersten Richtung doppelt so groß ist wie der Winkelraum der Beleuchtungsstrahlung der Beleuchtungsoptik (23).

3. Optisches System (24) gemäß Anspruch 1 oder 2, **dadurch gekennzeichnet, dass** das Retikel (17) relativ zum Strahlengang der Beleuchtungsstrahlung derart verkippt ist, dass seine Flächennormale (26) vollständig im Strahlenbündel der Beleuchtungsstrahlung der Projektionsoptik (19) liegt.

4. Optisches System (24) gemäß einem der Ansprüche 1 bis 3, **gekennzeichnet durch** einen Pupillenfacettenspiegel (10) mit einer halbkreisförmigen Ausbildung.

5. Optisches System (24) gemäß einem der Ansprüche 1 bis 4, **dadurch gekennzeichnet, dass** die Projektionsoptik (19) eine objektseitige numerische Apertur von mindestens 0,55 aufweist.

6. Optisches System (24) gemäß einem der Ansprüche 1 bis 5, **dadurch gekennzeichnet, dass** der Winkelraum der Beleuchtungsstrahlung der Projektionsoptik (19) am Retikel (17) in einer zweiten Richtung gleich groß ist wie der Winkelraum der Beleuchtungsstrahlung der Beleuchtungsoptik (23).

7. Optisches System (24) gemäß einem der Ansprüche 1 bis 6, **dadurch gekennzeichnet, dass** die Projektionsoptik (19) eine Mehrzahl von Spiegeln aufweist, wobei die ersten beiden Spiegel im Strahlengang der Projektionsoptik (19) eine einfach zusammenhängende Reflexionsfläche aufweisen.

8. Optisches System (24) gemäß einem der Ansprüche 1 bis 7, **dadurch gekennzeichnet, dass** sich die Einhüllende der Strahlenbündel der Projektionsoptik (19) und die Einhüllende der Strahlenbündel der Beleuchtungsoptik (23) nicht überlappen.

9. Pupillenfacettenspiegel (10) für eine Beleuchtungsoptik (23) eines optischen Systems gemäß einem der Ansprüche 1 bis 8, **gekennzeichnet durch** eine halbkreisförmige Ausbildung.

10. Pupillenfacettenspiegel (10) gemäß Anspruch 9, **gekennzeichnet durch** eine Mehrzahl von Pupillenfacetten (10), welche in einem x/y-Raster oder auf einem hexagonalen Raster angeordnet sind.

11. Pupillenfacettenspiegel (10) gemäß einem der Ansprüche 9 bis 10 **dadurch gekennzeichnet, dass** die Pupillenfaceteten (11) quadratische, runde, sechseckige oder achteckige Reflexionsflächen aufweisen.

12. Beleuchtungsoptik (23) für ein optisches System (24) gemäß einem der Ansprüche 1 bis 8, mit einer maximalen ausgangsseitigen Apertur, welche in einer ersten Richtung höchstens 70% so groß ist wie in einer hierzu senkrechten zweiten Richtung **gekennzeichnet durch** einen Pupillenfacettenspiegel (10) gemäß einem der Ansprüche 9 bis 11.

13. Projektionsbelichtungsanlage (1) für die Mikrolithographie umfassend
13.1. ein optisches System (24) gemäß einem der Ansprüche 1 bis 8 und
13.2. eine Strahlungsquelle (2) zur Erzeugung von Beleuchtungsstrahlung.

14. Verfahren zur Belichtung eines Wafers (22) mithilfe einer Projektionsbelichtungsanlage (1) umfassend die folgenden Schritte:
14.1. Bereitstellen einer Projektionsbelichtungsanlage (1) mit einem optischen System gemäß einem der Ansprüche 1 bis 8,
14.2. Bereitstellen eines Retikels (17) in einer Objektebene (16) der Projektionsbelichtungsanlage (1),
14.3. Bereitstellen eines Wafers (22) in einer Bildebene (21) der Projektionsbelichtungsanlage (1),
14.4. erstes Projizieren des Retikels (17) auf den Wafer (22) mithilfe der Projektionsbelichtungsanlage (1),
14.5. wobei zur Beleuchtung des Retikels (17) mittels der Projektionsbelichtungsanlage (1) eine Beleuchtungswinkelverteilung vorgegeben wird, welche gerade einem der Pole eines Dipolsettings entspricht.

15. Verfahren gemäß Anspruch 14, **gekennzeichnet durch** folgende Schritte:
15.5. Rotieren des Retikels (17) und des Wafers (22) um jeweils 180° um die optische Achse,
15.6. zweites Projizieren des Retikels (17) auf den Wafer (22) mithilfe der Projektionsbelichtungsanlage (1).

## Claims

1. Optical system (24) for a projection exposure apparatus (1), comprising
1.1 an illumination optical unit (23) for transferring illumination radiation to a reticle (17), and
1.2 a projection optical unit (19) for projecting the reticle (17) onto a wafer (22), **characterized in that**
1.3. the angle space of the illumination radiation of the illumination optical unit (23) and of the projection optical unit (19) at the reticle (17) is designed such that only one of the two first orders of diffraction of the illumination radiation reflected off the reticle (17) is contained in the beam of the projection optical unit (19).

2. Optical system (24) according to Claim 1, **characterized in that** the angle space of the illumination radiation of the projection optical unit (19) at the reticle (17) is twice as large in a first direction as the angle space of the illumination radiation of the illumination optical unit (23).

3. Optical system (24) according to Claim 1 or 2, **characterized in that** the reticle (17) is tilted relative to the beam path of the illumination radiation in such a way that its surface normal (26) lies entirely in the beam of the illumination radiation of the projection optical unit (19).

4. Optical system (24) according to one of Claims 1 to 3, **characterized by** a pupil facet mirror (10) having a semicircular embodiment.

5. Optical system (24) according to one of Claims 1 to 4, **characterized in that** the projection optical unit (19) has an object-side numerical aperture of at least 0.55.

6. Optical system (24) according to one of Claims 1 to 5, **characterized in that** the angle space of the illumination radiation of the projection optical unit (19) at the reticle (17) is the same size in a second direction as the angle space of the illumination radiation of the illumination optical unit (23).

7. Optical system (24) according to one of Claims 1 to 6, **characterized in that** the projection optical unit (19) has a plurality of mirrors, wherein the first two mirrors in the beam path of the projection optical unit (19) have a simply contiguous reflection surface.

8. Optical system (24) according to one of Claims 1 to 7, **characterized in that** the envelope of the beams of the projection optical unit (19) and the envelope of the beams of the illumination optical unit (23) do not overlap.

9. Pupil facet mirror (10) for an illumination optical unit (23) of an optical system according to one of Claims 1 to 8, **characterized by** a semicircular embodiment.

10. Pupil facet mirror (10) according to Claim 9, **characterized by** a plurality of pupil facets (10) which are arranged in an x/y grid or on a hexagonal grid.

11. Pupil facet mirror (10) according to one of Claims 9 and 10, **characterized in that** the pupil facets (10) have square, round, hexagonal or octagonal reflection surfaces.

12. Illumination optical unit (23) for an optical system (24) according to one of Claims 1 to 8, having an exit-side maximum aperture, which is at most 70% as large in a first direction as in a second direction perpendicular thereto, **characterized by** a pupil facet mirror (10) according to one of Claims 9 to 11.

13. Microlithographic projection exposure apparatus (1) comprising
13.1. an optical system (24) according to one of Claims 1 to 8, and
13.2. a radiation source (2) for generating illumination radiation.

14. Method for illuminating a wafer (22) with the aid of a projection exposure apparatus (1), comprising the following steps:
14.1. providing a projection exposure apparatus (1) with an optical system according to one of Claims 1 to 8,
14.2. providing a reticle (17) in an object plane (16) of the projection exposure apparatus (1),
14.3. providing a wafer (22) in an image plane (21) of the projection exposure apparatus (1),
14.4. first projecting of the reticle (17) onto the wafer (22) with the aid of the projection exposure apparatus (1),
14.5. wherein, for illuminating the reticle (17) by means of the projection exposure apparatus (1), an illumination angle distribution is specified which corresponds to precisely one of the poles of a dipole setting.

15. Method according to Claim 14, **characterized by** the following steps:
15.5. rotating the reticle (17) and the wafer (22) through 180° in each case about the optical axis,
15.6. second projecting of the reticle (17) onto the wafer (22) with the aid of the projection exposure apparatus (1).

## Revendications

1. Système optique (24) destiné à une installation d'exposition par projection (1), comprenant
1.1. une unité optique d'éclairage (23) destinée à transférer un rayonnement d'éclairage vers un réticule (17) et
1.2. une optique de projection (19) destinée à projeter le réticule (17) sur une plaquette (22), **caractérisé en ce que**
1.3. l'espace angulaire du rayonnement lumineux de l'optique d'éclairage (23) et de l'optique de projection (19) sur le réticule (17) est conçu de telle sorte que, sur les deux premiers ordres de diffraction du rayonnement lumineux réfléchi sur le réticule (17), un seul soit contenu dans le faisceau de l'optique de projection (19).

2. Système optique (24) selon la revendication 1, **caractérisé en ce que** l'espace angulaire du rayonnement d'éclairage de l'unité optique de projection (19) sur le réticule (17) dans une première direction est deux fois supérieur à l'espace angulaire du rayonnement d'éclairage de l'unité optique d'éclairage (23).

3. Système optique (24) selon la revendication 1 ou 2, **caractérisé en ce que** le réticule (17) est incliné par rapport au chemin de faisceau du rayonnement d'éclairage de telle sorte que sa normale à la surface (26) se situe entièrement dans le faisceau du rayonnement d'éclairage de l'optique de projection (19).

4. Système optique (24) selon l'une des revendications 1 à 3, **caractérisé par** un miroir à facettes de pupille (10) réalisé sous une forme semi-circulaire.

5. Système optique (24) selon l'une des revendications 1 à 4, **caractérisé en ce que** l'optique de projection (19) présente une ouverture numérique côté objet d'au moins 0,55.

6. Système optique (24) selon l'une des revendications 1 à 5, **caractérisé en ce que** l'espace angulaire du rayonnement d'éclairage de l'unité optique de projection (19) sur le réticule (17) dans une deuxième direction est de même taille que l'espace angulaire du rayonnement d'éclairage de l'unité optique d'éclairage (23).

7. Système optique (24) selon l'une des revendications 1 à 6, **caractérisé en ce que** l'unité optique de projection (19) comporte plusieurs miroirs, les deux premiers miroirs présentant une surface de réflexion simplement cohérente sur le chemin de faisceau de l'unité optique de projection (19).

8. Système optique (24) selon l'une des revendications 1 à 7, **caractérisé en ce que** l'enveloppe des faisceaux de l'optique de projection (19) et l'enveloppe des faisceaux de l'optique d'éclairage (23) ne se chevauchent pas.

9. Miroir à facettes de pupille (10) destiné à une optique d'éclairage (23) d'un système optique selon l'une des revendications 1 à 8, **caractérisé par** une réalisation semi-circulaire.

10. Miroir à facettes de pupille (10) selon la revendication 9, **caractérisé par** une pluralité de facettes de pupille (10) qui sont disposées selon une grille x/y ou sur une grille hexagonale.

11. Miroir à facettes de pupille (10) selon l'une des revendications 9 à 10, **caractérisé en ce que** les facettes de pupille (11) présentent des surfaces de réflexion carrées, rondes, hexagonales ou octogonales.

12. Unité optique d'éclairage (23) destinée à un système optique (24) selon l'une des revendications 1 à 8, ayant une ouverture maximale côté sortie qui, dans une première direction, est au plus égale à 70 % de sa valeur dans une deuxième direction perpendiculaire à celle-ci, **caractérisée par** un miroir à facettes de pupille (10) selon l'une des revendications 9 à 11.

13. Installation d'exposition par projection (1) destinée à la microlithographie, comprenant
13.1. un système optique (24) selon l'une des revendications 1 à 8 et
13.2. une source de rayonnement (2) destinée à produire un rayonnement d'éclairage.

14. Procédé d'exposition d'une plaquette (22) à l'aide d'une installation d'exposition par projection (1), comprenant les étapes suivantes :
14,1. fourniture d'une installation d'exposition par projection (1) comprenant un système optique selon l'une des revendications 1 à 8,
14,2. fourniture d'un réticule (17) dans un plan objet (16) de l'installation d'exposition par projection (1),
14,3. fourniture d'une plaquette (22) dans un plan image (21) de l'installation d'exposition par projection (1),
14.4. première projection du réticule (17) sur la plaquette (22) à l'aide de l'installation d'exposition par projection (1),
14.5. une répartition angulaire d'éclairage qui correspond exactement à l'un des pôles d'un réglage dipolaire étant prédéfinie pour l'éclairage du réticule (17) au moyen de l'installation d'exposition par projection (1).

15. Procédé selon la revendication 14, **caractérisé par** les étapes suivantes :
15,5. rotation respectivement de 180° du réticule (17) et de la plaquette (22) autour de l'axe optique,
15.6. deuxième projection du réticule (17) sur la plaquette (22) à l'aide de l'installation d'exposition par projection (1).
